Europäisches Patentamt

European Patent Office

Office européen des brevets

(19)

(11) Veröffentlichungsnummer : **0 056 852**
**B1**

(12) # EUROPÄISCHE PATENTSCHRIFT

(45) Veröffentlichungstag der Patentschrift :
28.08.85

(51) Int. Cl.⁴ : **G 01 R 22/02, H 01 M 10/36**

(21) Anmeldenummer : **81109641.1**

(22) Anmeldetag : **12.11.81**

(54) **Ladungszelle.**

(30) Priorität : **26.01.81 CH 468/81**

(43) Veröffentlichungstag der Anmeldung :
**04.08.82 Patentblatt 82/31**

(45) Bekanntmachung des Hinweises auf die Patenterteilung : **28.08.85 Patentblatt 85/35**

(84) Benannte Vertragsstaaten :
**CH DE FR GB IT LI NL SE**

(56) Entgegenhaltungen :
**EP-A- 0 000 785
DE-A- 2 806 464
US-A- 3 704 174
US-A- 3 708 729
US-A- 3 710 201
Die Akte enthält technische Angaben, die nach dem Eingang der Anmeldung eingereicht wurden und die nicht in dieser Patentschrift enthalten sind.**

(73) Patentinhaber : **LGZ LANDIS & GYR ZUG AG**

**CH-6301 Zug (CH)**

(72) Erfinder : **Moser, Jean-Fréderic
Stolzengrabenstrasse 57
CH-6317 Oberwil (CH)**
Erfinder : **Baltes, Heinrich Peter
Zeughausgasse 21
CH-6300 Zug (CH)**

(74) Vertreter : **Müller, Hans-Jürgen, Dipl.-Ing. et al
Müller, Schupfner & Gauger Lucile-Grahn-Strasse 38
Postfach 80 13 69
D-8000 München 80 (DE)**

## Beschreibung

Die Erfindung bezieht sich auf eine Ladungszelle mit einem Festkörper-Dielektrikum der im Oberbegriff des Patentanspruchs 1 genannten Gattung und deren Anwendung.

Eine derartige Ladungszelle ist bereits bekannt (EP-A-0 000 785). Das bei dieser bekannten Ladungszelle verwendete Festkörper-Dielektrikum weist eine glasige amorphe Struktur auf. Die Ionen werden über einen Sumpf abgeführt. Diese Ladungszelle wird als Kondensator, Bolometer und elektrolytische Zelle verwendet. Solche elektrolytische Ladungszellen arbeiten nach dem Faraday-Prinzip und dienen zur Messung elektrischer Ladungsquantitäten (Coulomb).

Solche Coulometer sind ebenfalls bereits bekannt (US-A-3 708 729 und US-A-3 710 201). Solche Zellen bestehen vielfach aus 2 in der Regel metallischen Elektroden, beispielsweise Silber und Quecksilber, die durch eine elektrolytische Lösung voneinander getrennt sind. Ein die Ladungszelle durchfliessender elektrischer Strom transferiert Metallionen von einer Elektrode zur anderen und lagert sie dort ab. Dieser Vorgang ist reversibel, so dass durch Umkehrung der Stromrichtung auch eine Nullrückstellung der Ladungszelle möglich ist.

Elektrolytische Ladungszellen dieser Gattung haben aber Nachteile : Sie sind nicht in integrierte Halbleiterschaltungen integrierbar, sie sind gegen mechanische Erschütterungen empfindlich, ihre Lebensdauer ist beschränkt, darüber hinaus ist auch die Ionenkonzentration temperaturabhängig und über längere Zeit, in der Grössenordnung von Jahren beispielsweise, aufgrund chemischer Reaktionen der elektrolytischen Lösung mit dem Gehäusematerial nich konstant.

Der Erfindung liegt die Aufgabe zugrunde, eine Ladungszelle der eingangsgenannten Gattung dahingehend zu verbessern, dass sie praktisch ohne Ladungsverlust betreibbar ist, und zwar auch reversibel.

Die Erfindung ist im Patentanspruch 1 und in den Patentansprüchen 8 und 9 gekennzeichnet, und in Unteransprüchen sind weitere Ausbildungen derselben beansprucht.

Im Gegensatz zur eingangsgenannten vorbekannten Ladungszelle wird bei der Erfindung ein Material als Dielektrikum verwendet, das nach der Planartechnologie mit Ionen versehen ist. Diese Planartechnologie wird auch als Ionenimplantation angewendet. Der Halbleiter wird dabei mit solchen Ionen dotiert, die zwar bei der Ladungsübertragung von einer zur anderen Elektrode wandern können, das Dielektrikum aber praktisch nicht mehr verlassen. Hierdurch werden sogenannte trapped-Ionen ausgenutzt, welche sonst in den Halbleitern immer als störend empfunden werden. Die Erfindung nutzt diesen angeblichen Nachteil zur Lösung der obengenannten Aufgabe aus.

Ein Ausführungsbeispiel der Erfindung ist in der Zeichnung dargestellt und wird im folgenden näher beschrieben.

Es zeigen :

Figur 1 eine festkörperphysikalische Ladungszelle in drei Zuständen,

Figur 2 Umschaltkennlinien einer Ladungszelle,

Figur 3 eine integrierbare Ladungszelle und

Figur 4 ein Beschaltungsbeispiel einer Ladungszelle.

Gleiche Bezugszahlen bezeichnen in allen Figuren der Zeichnung gleiche Teile.

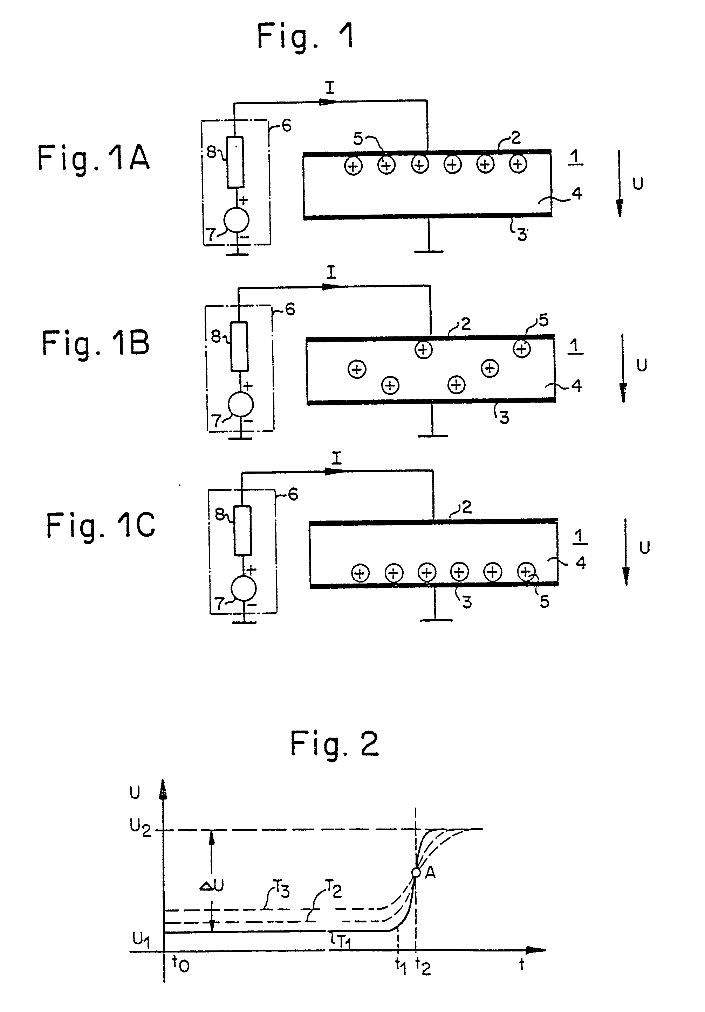

Beschreibung der Fig. 1 und der Fig. 2

Die in der Fig. 1 dargestellte festkörperphysikalische Ladungszelle 1 besteht im wesentlichen aus einer ersten Elektrode 2, einer zweiten Elektrode 3 und einem zwischen den beiden Elektroden 2 und 3 angeordneten Dielektrikum 4, in welchem eine vorgegebene Quantität $Q_{ref}$ positiver Ladungsträger 5 eingebaut ist. Die zweite Elektrode 3 liegt an Masse, und die erste Elektrode 2 wird vom positiven Pol einer Gleichstromquelle 6 gespeist, dargestellt durch eine Spannungsquelle 7 und einen zu dieser in Reihe geschalteten Innenwiderstand 8. Beide Elektroden 2 und 3 sind aus elektrisch gut leitendem Metall, z. B. aus Gold oder Aluminium, hergestellt.

Grundgedanke der Erfindung ist die Ausnützung des sonst in der Silizium-Planartechnologie höchst unerwünschten Einbaus von persistenten positiven Ladungsträgern, wie z. B. $Na^+$-Ionen, in z. B. einer Siliziumoxidschicht, die als « trapped ions » diese nicht mehr verlassen und weder durch thermische Diffusion noch durch Anlegen eines elektrischen Feldes vertrieben werden können. In der klassischen Silizium-Planartechnologie muss daher peinlich sauberes Arbeiten den Einbau der sonst allgegenwärtigen $Na^+$-Ionen verhindern, da andernfalls unerwünschte Leckströme und Störkapazitäten entstehen.

Dieser Effekt wird für die erfindungsgemässe Ladungszelle 1 ausgenutzt, indem absichtlich eine vorgegebene Quantität $Q_{ref}$ solcher persistenten positiven ladungsträger 5 in einem aus einem Festkörper hergestellten Dielektrikum 4 mittels z. B. einer Ionenimplantation eingebaut werden. Als positive Ladungsträger 5 eignen sich vor allem Alkaliionen.

In der Fig. 2 ist die Umschaltkennlinie der Ladungszelle 1 dargestellt, die das zeitliche Verhalten des Spannungsabfalls U über der Ladungszelle 1 wiedergibt.

Annahmen :

— Zu Beginn, d. h. im Zeitraum $t < t_0$, seien z. B. alle positiven Ladungsträger 5 des Dielektrikums 4 an der Schichtgrenze 2-4 lokalisiert (Fig. 1A).

— Im Zeitpunkt $t = t_0$ werde die positive Spannung der Gleichstromquelle 6 mit Hilfe eines nicht gezeichneten Schalters auf die erste Elektrode 2 geschaltet.

Das durch diese positive Spannung im Dielektrikum 4 erzeugte elektrische Feld lässt die positiven Ladungsträger 5 im Dielektrikum 4 in Feldrichtung zur Schichtgrenze 4-3 wandern (Fig. 1B). Es fliesst somit während des Zeitraums $t = t_0$ bis $t = t_1$ ein Strom positiver Ladungsträger 5, und der elektrische Innenwiderstand $R_Q$ der Ladungszelle 1 ist sehr niedrig im Vergleich zum Innenwiderstand 8. Der Spannungsabfall U über der Ladungszelle 1 bleibt während dieser Zeit konstant, ist klein und besitzt den Wert $U_1$ (Fig. 2), solange alle Ionen am Transport beteiligt sind. Sobald im Zeipunkt $t = t_1$ alle positiven Ladungsträger 5 die Grenzschicht 4-3 erreicht haben (Fig. 1C), fliesst kein Strom positiver Ladungsträger 5 mehr, so dass der Spannungsabfall U über der Ladungszelle 1 plötzlich auf den hohen Spannungswert $U_2$ der Spannungsquelle 7 ansteigt, da die Ladungszelle 1 jetzt als reiner Kondensator wirkt und von der hochohmigen Stromquelle 6 sehr schnell auf den Wert $U_2$ aufgeladen wird (Fig. 2).

Dieser Vorgang ist reversibel, da durch Umpolung der Gleichstromquelle 6 die Wanderung positiver Ladungsträger 5 wieder rückgängig gemacht werden kann, da diese positiven Ladungsträger 5 dann von der Grenzschicht 4-3 zurück zur Grenzschicht 2-4 fliessen. Wegen der « Gefangenschaft » der positiven Ladungsträger 5 im Dielektrikum 4 geschieht dieses Hin- und Herschieben elektrischer Ladungen ohne Ladungsverlust.

Wie bei den meisten Halbleitereffekten ist jedoch eine starke Temperaturabhängigkeit vorhanden. Für den Umladestrom I gilt z. B. die Gleichung $I \simeq (E/T) \cdot e^{-(\Delta E_{Ai}/kT)}$, wobei $\Delta E_{Ai}$ die Aktivierungsenergie des Dielektrikums 4, E das angelegte elektrische Feld, k die Boltzmann-Konstante und T die absolute Temperatur darstellt. Somit ist der Umladestrom I und damit auch der elektrische Innenwiderstand $R_Q$ der Ladungszelle 1 eine Funktion der Temperatur. Dies hat zur Folge, dass der Wert $U_1$ des Spannungsabfalls U über der Ladungszelle 1 ebenfalls von der Spannungsabfalls U über der Ladungszelle 1 ebenfalls von der Temperatur abhängt. Diese Temperaturabhängigkeit von $U_1$ kann ausgenutzt werden z. B. bei der Verwendung der Ladungszelle 1 als Temperaturfühler. Die in der Fig. 2 voll ausgezogene Kennlinie gilt für die Temperatur $T = T_1$. Zwei weitere gestrichelt gezeichnete Kennlinien gelten jeweils für die Temperaturen $T = T_2$ und $T = T_3$. Der Endwert $U_2$ ist für alle drei Kennlinien gleich und wird nur durch die Spannungsquelle 7 bestimmt. Der Angangswert $U_1$ und damit auch $\Delta U = U_2 - U_1$ ist dagegen für jede der drei Kennlinien verschieden. Um den Einfluss der Temperatur auf den Umladestrom I möglichst klein zu halten, muss der Wert $R_i$ des Innenwiderstandes 8 der Gleichstromquelle 6 sehr viel grösser gewählt sein als der Wert des Innenwiderstandes $R_Q$ der Ladungszelle 1. Der Wert des Umladestroms $I = U_2/(R_i + R_Q) \simeq U_2/R_i$ wird dann praktisch nicht mehr durch $R_Q$ mitbestimmt und ist demnach so gut wie temperaturunabhängig.

Die drei Kennlinien der Fig. 2 haben annähernd einen gemeinsamen Wert im Zeitpunkt $t = t_2$ (Punkt A). Wegen der Steilheit der Kennlinien im Punkt A ist $t_2$ annähernd gleich $t_1$. Mit anderen Worten : der Zeitpunkt $t = t_2 \simeq t_1$ und damit auch die Umladezeit $t_2 - t_0$ der Ladungszelle 1 ist temperaturunabhängig. Die Temperaturunabhängigkeit der Umladezeit $t_2 - t_0$ bzw. von dessen Kehrwert der Umladefrequenz $f = 1/(t_2 - t_0)$ ermöglicht eine genaue und temperaturunabhängige Messung des Wertes von

$$\int_{t_0}^{t_2} I \, dt = I \, (t_2 - t_0) = I/f = Q_{ref}.$$

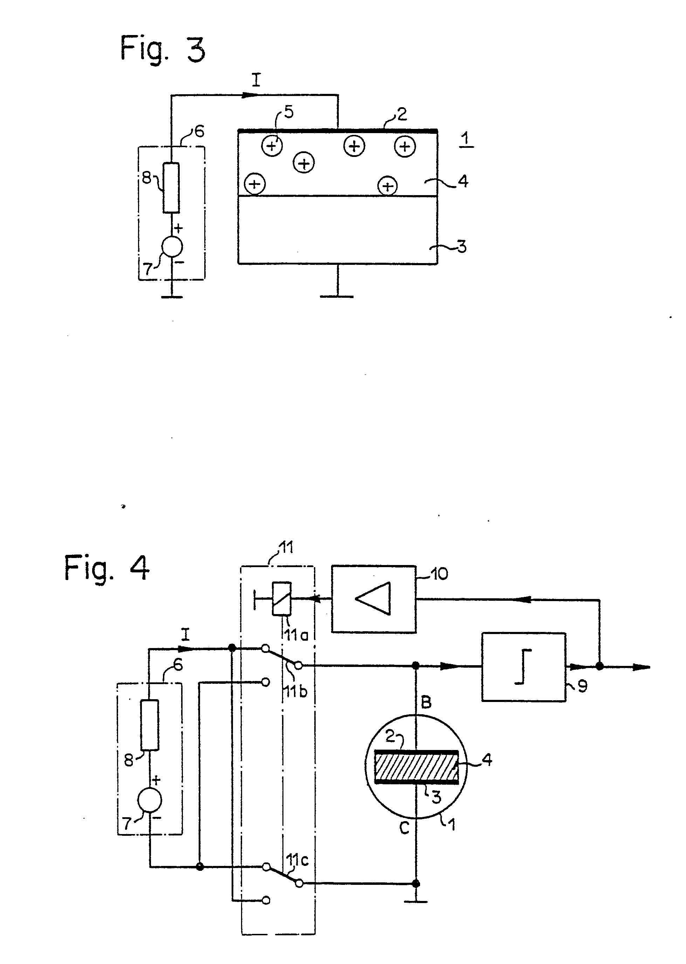

Beschreibung der Fig. 3

In der Darstellung der Fig. 3 ist die metallische zweite Elektrode 3 durch ein mit einem Drahtanschluss versehenes Halbleiter-Substrat aus n-, $n^+$-, p- oder $p^+$-Silizium ersetzt worden. Als Dielektrikum 4 dient hier vorteilhafterweise eine Dünnschicht aus $SiO_2$, da dann die bekannten Methoden der Silizium-Planartechnologie benutzbar sind und die Ladungszelle 1 in eine sogenannte integrierte Schaltung integrierbar ist. Dies hat wiederum den Vorteil, dass eventuell verbleibende sehr schwache Temperatureinflüsse auskompensierbar sind, indem auf dem Halbleiter-Substrat der integrierten Schaltung in der Nähe der Ladungszelle 1 eine zweite, von einem bekannten konstanten Strom durchflossene Ladungszelle integriert wird, deren Referenz-Umladefrequenz dann zur Korrektur des Temperatureinflusses auf die gemessene Umladefrequenz f der ersten Ladungszelle 1 herangezogen werden kann. Beide Ladungszellen haben, bedingt durch ihre Nähe auf dem Halbleiter-Substrat, gleiche Temperatur.

Dünnschichten aus $SiO_2$ können z. B durch thermische Oxydation des Silizium-Halbleiter-Substrates hergestellt werden ; in ihnen lassen sich während des Oxydationsprozesses oder nachträglich mittels Ionenimplantation Ionen, z. B. $Na^+$- oder $Li^+$- Ionen, einbauen.

Beschreibung der Fig. 4

In der Fig. 4 ist ein Beschaltungsbeispiel der Ladungszelle 1 dargestellt. Gezeichnet sind ausser den bereits bekannten Teilen ein Spannungsdetektor 9, ein Verstärker 10 und ein elektromagnetisches Relais 11, das eine Spule 11a, einen ersten Umschaltkontakt 11b und einen zweiten Umschaltkontakt 11c besitzt. Ein erster Pol B der Ladungszelle 1 ist mit dem Eingang des Spannungsdetektors 9, über den Arbeitskontakt des ersten Umschaltkontaktes 11b mit dem negativen Pol der Gleichstromquelle 6 und über den Ruhekontakt des gleichen Umschaltkontaktes

11b mit deren positivem Pol verbunden. Der zweite Pol C der Ladungszelle 1 liegt an Masse und über den Arbeitskontakt des zweiten Umschaltkontaktes 11c am positiven Pol der Gleichstromquelle 6 und über den Ruhekontakt des gleichen Umschaltkontaktes 11c an deren negativem Pol. Der Ausgang des Spannungsdetektors 9 steuert den Eingang des Verstärkers 10 und ist gleichzeitig der Ausgang der Gesamtschaltung. Ein erster Pol der Spule 11a des elektromagnetischen Relais 11 liegt an Masse, während der andere zweite Pol vom Ausgang des Verstärkers 10 gespeist wird.

Die beiden Umschaltkontakte 11b und 11c des elektromagnetischen Relais 11 gestatten die Umpolung der Gleichstromquelle 6, so dass der Umladestrom I die Ladungszelle 1 einmal von B nach C und ein andermal von C nach B durchfliesst. Der Eingang des Spannungsdetektors 9 ist hochohmig und belastet den Ladestromkreis der Ladungszelle 1 kaum. Sobald der Absolutwert der Spannung am Pol B der Ladungszelle 1 einen gewissen, in der Fig. 2 durch den Punkt A dargestelleten Wert überschreitet, schaltet der Ausgang des Spannungsdetektors 9 mit Hilfe des Verstärkers 10 das elektromagnetische Relais 11 und damit auch die Polarität der Gleichstromquelle 6 um. Jede Umschaltflanke am Ausgang des Spannungsdetektors 9 ist somit ein Zeichen, dass die Gleichstromquelle 6 mit Hilfe des Umladestromes I eine gewisse, vorgegebene Quantität $Q_{ref}$ elektrischer Ladungen der Ladungszelle 1 geliefert hat. Oder mit anderen Worten, die Anzahl Umschaltimpulse am Ausgang des Spannungsdetektors 9 ist ein Mass für die gesamte Quantität Q elektrisch positiver Ladungen, welche von der Gleichstromquelle 6 der Ladungszelle 1 geliefert wurden.

Ist der Umladestrom I proportional irgend einer Messgrösse, z. B. der momentanen Scheinleistung $P = u \cdot i$ eines elektrischen Verbrauchers, und ist ein dann benötigter Messgrösse/Strom-Wandler hochohmig, d. h. stellt er eine Stromquelle dar, so kann die in der Fig. 4 gezeigte Schaltung zur Messung des Zeitintegrals dieser Messgrösse, d. h. im vorliegenden Beispiel der verbrauchten Energie $\int_0^t P \cdot dt = \int_0^t u \cdot i \cdot dt = K \int_0^t I dt = K \cdot Q = K \cdot Q_{ref} \cdot N$ verwendet werden, wobei K eine Proportional-Konstante und N die während der Zeit t am Ausgang des Spannungsdetektors 9 erscheinende Anzahl Umschaltimpulse darstellt.

## Patentansprüche

1. Ladungszelle mit einem Festkörper-Dielektrikum (4) zwischen zwei elektrisch leitenden Elektroden (2, 3), bei dem das Dielektrikum (4) eine vorgegebene Quantität (Q ref) positiver Ladungsträger (5) in Form von positiven Ionen aufweist, dadurch gekennzeichnet, daß das Dielektrikum nach der Planartechnologie mit den positiven Ionen (5) versehen ist, welche das Dielektrikum (4) bei Ladungsübertragung von einer Elektrode (2) zur anderen Elektrode (3) durch Ionen-Wanderung nicht mehr verlassen und den Spannungsabfall (U) zwischen den Elektroden (2, 3) bei Beendigung der Ionen-Wanderung plötzlich erhöhen.

2. Ladungszelle nach Anspruch 2, dadurch gekennzeichnet, daß die positiven Ionen Alkaliionen sind.

3. Ladungszelle nach Anspruch 1 oder 2, dadurch gekennzeichnet, daß das Dielektrikum (4) als Dünnschicht ausgebildet ist.

4. Ladungszelle nach einem der Ansprüche 1 bis 3, dadurch gekennzeichnet, daß das Dielektrikum (4) aus $SiO_2$ besteht.

5. Ladungszelle nach einem der Ansprüche 1 bis 4, dadurch gekennzeichnet, daß beide Elektroden (2, 3) aus elektrisch gut leitendem Metall bestehen.

6. Ladungszelle nach einem der Ansprüche 1 bis 5, dadurch gekennzeichnet, dab eine der beiden Elektroden aus einem Halbleiter-Substrat besteht.

7. Ladungszelle nach Anspruch 6, dadurch gekennzeichnet, daß das Halbleiter-Substrat aus n-, $n^+$-, p- oder $p^+$-Silizium besteht.

8. Anwendung einer Ladungszelle nach einem der Ansprüche 1 bis 7 als Ladungs-Integrator oder Ladungs-Referenzeinheit.

9. Anwendung einer Ladungszelle nach Anspruch 6 oder 7, dadurch gekennzeichnet, daß die Ladungszelle auf dem Halbleiter-Substrat einer sogenannten integrierten Schaltung integriert ist.

10. Anwendung einer Ladungszelle nach Anspruch 9, dadurch gekennzeichnet, daß auf dem Halbleiter-Substrat der integrierten Schaltung in der Nähe der ersten Ladungszelle eine zweite von einem bekannten konstanten Strom umgeladene Ladungszelle nach einem der Ansprüche 6 oder 7 integriert ist, deren Referenz-Umladefrequenz zur Korrektur des Temperatureinflusses auf die gemessene Umladefrequenz der ersten Ladungszelle dient.

## Claims

1. A charge cell comprising a solid state dielectric (4) between two electrically conductive electrodes (2, 3), wherein the dielectric (4) has a predetermined quantity (Q ref) of positive charge carriers (5) in the form of positive ions, characterised in that the dielectric is provided in accordance with the planar technology with the positive ions (5) which no longer leave the dielectric (4) upon charge transfer from one electrode (2) to the other electrode (3) by ion migration, and suddenly increase the voltage drop (U) between the electrodes (2, 3) upon termination of the ion migration.

2. A cell according to claim 2, characterised in that the positive ions are alkaline ions.

3. A cell according to claim 1 or claim 2, characterised in that the dielectric (4) is formed as a thin film.

4. A cell according to one of claims 1 to 3, characterised in that the dielectric (4) comprises $SiO_2$.

5. A cell according to one of claims 1 to 4, characterised in that both electrodes (2, 3) comprise metal which is a good electrical conductor.

6. A cell according to one of claims 1 to 5, characterised in that one of the two electrodes comprises a semiconductor substrate.

7. A cell according to claim 6, characterised in that the semiconductor substrate comprises n-, $n^+$-, p-, or $p^+$-silicon.

8. Use of a cell according to one of claims 1 to 7, as a charge integrator or charge reference unit.

9. Use of a cell according to claim 6 or claim 7, characterised in that the cell is integrated on the semiconductor substrate of a so-called integrated circuit.

10. Use of a first charge cell according to claim 9, characterised in that a second charge cell whose charge is changed by a known constant current, in accordance with one of claims 6 or 7, is integrated on the semiconductor substrate of the integrated circuit in the vicinity of the first cell, the reference charge reversal frequency of the second cell serving to correct the temperature influence on the measured charge reversal frequency of the first cell.

**Revendications**

1. Cellule de charge comportant un diélectrique à corps solide (4) entre deux électrodes électriquement conductrices (2, 3), où le diélectrique (4) comporte une quantité prédéterminée $_f(Q_{ref})$ de porteurs de charges positives (5) sous la forme d'ions positifs, caractérisée en ce que le diélectrique est pourvu des ions positifs (5) conformément à la technologie planaire, ces ions ne pouvant plus quitter le diélectrique (4), lors d'un transfert de charge d'une électrode (2) à l'autre électrode (3) à propagation d'ions, et augmentant brusquement la chute de tension (U) entre les électrodes (2, 3) à la fin de la propagation des ions.

2. Cellule de charge selon la revendication 1, caractérisée en ce que les ions positifs sont des ions alcalins.

3. Cellule de charge selon la revendication 1 ou 2, caractérisée en ce que le diélectrique (4) est agencé sous forme d'une couche mince.

4. Cellule de charge selon une des revendications 1 à 3, caractérisée en ce que le diélectrique (4) se compose de $SiO_2$.

5. Cellule de charge selon une des revendications 1 à 4, caractérisée en ce que les deux électrodes se composent d'un métal électriquement bon conducteur.

6. Cellule de charge selon une des revendications 1 à 5, caractérisée en ce qu'une des deux électrodes se composent d'un substrat en semiconducteur.

7. Cellule de charge selon la revendication 6, caractérisée en ce que le substrat en semiconducteur se compose de silicium de type n, $n^+$, p ou $p^+$.

8. Utilisation d'une cellule de charge selon une des revendications 1 à 7 comme un intégrateur de charge ou comme une unité de référence de charge.

9. Utilisation d'une cellule de charge selon la revendication 6 ou 7, caractérisée en ce que la cellule de charge est intégrée dans le substrat en semiconducteur de ce qu'on appelle un circuit intégré.

10. Utilisation d'une première cellule de charge selon la revendication 9, caractérisée en ce que sur le substrat en semiconducteur du circuit intégré, au voisinage de la première cellule de charge, est intégrée une seconde cellule de charge selon une des revendications 6 ou 7, qui a été soumise à commutation de charge par un courant constant connu et dont la fréquence de commutation de charge de référence sert la correction de l'influence de la température sur la fréquence mesurée de commutation de charge de la première cellule de charge.

# Fig. 1

Fig. 1A

Fig. 1B

Fig. 1C

# Fig. 2

Fig. 3

I

Fig. 4